# EUROPEAN PATENT SPECIFICATION

(11) **EP 3 390 933 B1**
(45) Date of publication and mention of the grant of the patent: **02.06.2021**
(21) Application number: 16820429.5
(22) Date of filing: 08.12.2016
(51) Int. Cl.: F25D 29/00

(54) **METHODS AND SYSTEMS FOR MONITORING POWER SUPPLY FOR A CONTAINER**
VERFAHREN UND SYSTEME ZUR ÜBERWACHUNG DER STROMVERSORGUNG FÜR EINEN BEHÄLTER
PROCÉDÉS ET SYSTÈMES DE SURVEILLANCE DE L'ALIMENTATION ÉLECTRIQUE D'UN CONTENEUR

(30) Priority: 18.12.2015 US 201562269190 P
(43) Date of publication of application: 24.10.2018
(73) Proprietor: Carrier Corporation, Farmington, Connecticut 06032 (US)
(72) Inventor: RUSIGNUOLO, Giorgio, East Syracuse New York 13057 (US); CHEN, Yu H., Syracuse New York 13221 (US); BEASLEY, Marc, Beverly Massachusetts 01915 (US); DIMAGGIO, Luke, Athens Georgia 30601 (US); KUMAR, Kartik, 3047 BL Rotterdam (NL)
(74) Representative: Schmitt-Nilson Schraud Waibel Wohlfrom Patentanwälte Partnerschaft mbB
(86) International application number: PCT/US2016/065532
(87) International publication number: WO 2017/105988

(56) References cited:
- WO-A2-2007/084866
- US-A1- 2013 106 607
- US-B1- 6 708 507

## Description

### BACKGROUND

The subject matter disclosed herein generally relates to containers for cargo and, more particularly, to systems and methods for monitoring power supply for a container having a refrigeration unit.

A shipping container is a container with strength suitable to withstand shipment, storage, and handling. Various shipping containers in the transportation of cargo may include refrigeration units and/or systems. The cargo in such containers could be any type of cargo requiring climate control and/or protection from "hot" or "cold" conditions. Refrigeration units may be married to and/or configured with an insulated box or container for the carriage of cargo and may include, but is not limited to, refrigerated containers, refrigerated trailers, refrigerated boxcars, refrigerated air cargo containers, refrigerated trucks, etc. The refrigeration unit controls the temperature of the conditioned air either delivered to and/or returning from the cargo space. A controller may be used to control air conditions within the container. For example, a controller may be used to monitor temperature and other conditions with a processor, and thus control a refrigeration unit for the regulation of conditioned air either delivered to and/or returning from a cargo space.

An advantage of using a multimodal refrigeration unit configured with a container to ship cargo is that the container does not require any handling of the cargo itself when changing modes of transportation. For example, when transferring cargo between a train, a ship, a truck, and/or an aircraft, the container is configured to reduce damage and loss, allows cargo to be transported faster, and improves security.

Maintaining proper or desired temperatures within the container may be important to ensure any cargo contained within the container does not spoil or otherwise become damaged due to air quality conditions. Thus, it may be desired to ensure power is properly and appropriately supplied to the refrigeration unit to maintain the proper or desired temperatures for the duration that the cargo is contained within the container.

WO 2007/084866 A2 shows a refrigerator system for storing pharmaceutical product containers, such as vials, ampules, syringes, bottles, medication tubes, blister packs and cartons, at the point of dispensing. The invention use product identification technology, such as radio-frequency identification (RFID) tags and readers, to uniquely identify containers as they are added to or removed from the cold storage compartment of the refrigerator, and automatically retrieve from a local or remote database a variety of details associated with the containers and their contents, such as manufacturing data, expiration dates, time out of refrigeration, inventory levels, safety information, usage statistics, known contraindications and warnings, etc. The invention is configured to monitor and report temperature faults, power failures and other anomalies associated with the refrigerator or cold storage compartment.

### SUMMARY

According to one embodiment, a system for monitoring power supply to a refrigeration unit of a container is provided. The system includes one or more cargo sensors located within the container configured to detect a cargo within the container, a power connector configured to receive power from a power supply, the power connector operably connected to the refrigeration unit to supply power thereto, a power supply sensor operably connected to the power connector, the power supply sensor configured to detect a lack of power supplied through the power connector, and a controller in communication with the one or more cargo sensors and the power supply sensor. The controller is configured to store predetermined information related to power requirements of the refrigeration unit, wherein the predetermined information includes a maximum time period of a powered-off state, receive data from the one or more cargo sensors, receive data from the power supply sensor, and when the data from the one or more cargo sensors indicates the presence of cargo within the container and the data from the power supply sensor indicates a lack of power for a duration that exceeds the maximum time period, the controller is configured to provide an indicator that the refrigeration unit does not have power.

In addition to one or more of the features described above, or as an alternative, further embodiments of the system may include that at least one sensor of the one or more cargo sensors is a proximity sensor.

In addition to one or more of the features described above, or as an alternative, further embodiments of the system may include that the power supply sensor is configured to detect a voltage received from a power supply at the power connector.

In addition to one or more of the features described above, or as an alternative, further embodiments of the system may include that the indicator is one of a light or a noise provided at the container.

In addition to one or more of the features described above, or as an alternative, further embodiments of the system may include that the indicator is a message transmitted to a user.

In addition to one or more of the features described above, or as an alternative, further embodiments of the system may include a plurality of containers, each container having one or more cargo sensors and each container having a power supply sensor, the system further comprising the controller in communication with each of the plurality of containers.

In addition to one or more of the features described above, or as an alternative, further embodiments of the system may include that, when one container of the plurality of containers has a lack of power for a duration that exceeds a maximum time period of the respective container, the indicator is configured to identify which of the plurality of containers has a lack of power for a duration that exceeds the maximum time period.

In addition to one or more of the features described above, or as an alternative, further embodiments of the system may include that the predetermined information is based on a cargo type loaded into the container.

In addition to one or more of the features described above, or as an alternative, further embodiments of the system may include that the controller is further configured to log a duration of time that exceeds the maximum time period.

According to another embodiment, a method for monitoring power supply to a refrigeration unit of a container is provided. The method includes loading, at a controller, predetermined information related to related to power requirements of the refrigeration unit, wherein the predetermined information includes a maximum time period of a powered-off state, detecting, with one or more cargo sensors, the presence of cargo within the container, monitoring, with a power supply sensor, a power supplied to the refrigeration unit through a power connector, and providing an indicator when it is determined that the refrigeration unit is without power for a duration that exceeds the maximum time period.

In addition to one or more of the features described above, or as an alternative, further embodiments of the method may include that at least one sensor of the one or more cargo sensors is a proximity sensor.

In addition to one or more of the features described above, or as an alternative, further embodiments of the method may include that the power supply sensor is configured to detect a voltage received from a power supply at the power connector.

In addition to one or more of the features described above, or as an alternative, further embodiments of the method may include that the indicator is one of a light or a noise provided at the container, the method further comprising activating said light or noise.

In addition to one or more of the features described above, or as an alternative, further embodiments of the method may include that the indicator is a message transmitted to a user, the method further comprising transmitting said message.

In addition to one or more of the features described above, or as an alternative, further embodiments of the method may include a plurality of containers, each container having one or more cargo sensors and each container having a power supply sensor, the method further comprising monitoring each of the plurality of containers with the controller.

In addition to one or more of the features described above, or as an alternative, further embodiments of the method may include that, when one container of the plurality of containers has a lack of power for a duration that exceeds a maximum time period of the respective container, the method further comprises identify which of the plurality of containers has a lack of power exceeding the maximum time period.

In addition to one or more of the features described above, or as an alternative, further embodiments of the method may include that the predetermined information is based on a cargo type loaded into the container.

In addition to one or more of the features described above, or as an alternative, further embodiments of the method may include logging a duration of time that exceeds the maximum time period.

Technical effects of embodiments of the present disclosure include a systems and processes for checking and monitoring proper power supplied to a refrigeration unit of a container such that proper temperatures or other air quality conditions may be maintained within the container.

The foregoing features and elements may be combined in various combinations without exclusivity, unless expressly indicated otherwise. These features and elements as well as the operation thereof will become more apparent in light of the following description and the accompanying drawings. It should be understood, however, that the following description and drawings are intended to be illustrative and explanatory in nature and non-limiting.

### BRIEF DESCRIPTION OF THE DRAWINGS

The subject matter is particularly pointed out and distinctly claimed at the conclusion of the specification. The foregoing and other features, and advantages of the present disclosure are apparent from the following detailed description taken in conjunction with the accompanying drawings in which:
FIG. 1A is a schematic view of an exemplary embodiment of a trailer system including a container having a refrigeration unit and a cargo compartment;
FIG. 1B is a schematic view of an exemplary embodiment of a refrigeration unit for a cargo compartment of the container of FIG. 1A;
FIG. 2 is a schematic illustration of a container and cargo contained therein;
FIG. 3 is a schematic illustration of a container configured in accordance with an embodiment of the present disclosure; and
FIG. 4 is a flow process in accordance with an embodiment of the present disclosure.

### DETAILED DESCRIPTION

As shown and described herein, various features of the disclosure will be presented. Various embodiments may have the same or similar features and thus the same or similar features may be labeled with the same reference numeral, but preceded by a different first number indicating the figure to which the feature is shown. Thus, for example, element "a" that is shown in FIG. X may be labeled "Xa" and a similar feature in FIG. Z may be labeled "Za." Although similar reference numbers may be used in a generic sense, various embodiments will be described and various features may include changes, alterations, modifications, etc. as will be appreciated by those of skill in the art, whether explicitly described or otherwise would be appreciated by those of skill in the art.

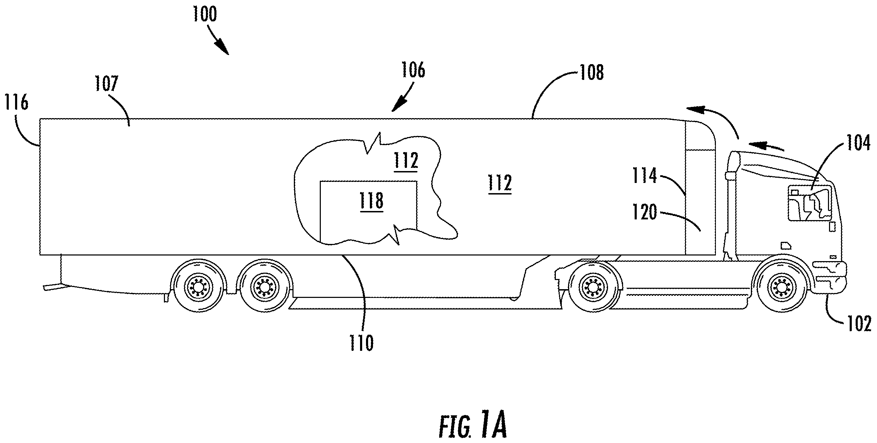

Shown in FIG. 1A is a schematic of an embodiment of a trailer system 100 having a container system 106 as part of a trailer. The trailer system 100 includes a tractor 102 including an operator's compartment or cab 104 and also including an engine, which acts as the drive system of the trailer system 100. A container system 106 is coupled to the tractor 102. The container system 106 is a refrigerated trailer and includes a top wall 108, a directly opposed bottom wall 110, opposed side walls 112, and a front wall 114, with the front wall 114 being closest to the tractor 102, the walls 108, 110, 112, 114 defining a container 107. The container 107 further includes a door or doors (not shown) at a rear wall 116, opposite the front wall 114. The walls of the container 107 define a cargo space. The container 107 is configured to maintain a cargo 118 located inside the cargo space at a selected temperature through the use of a refrigeration unit 120 located on or next to the container 107. The refrigeration unit 120, as shown in FIG. 1A, is located at or attached to the front wall 114.

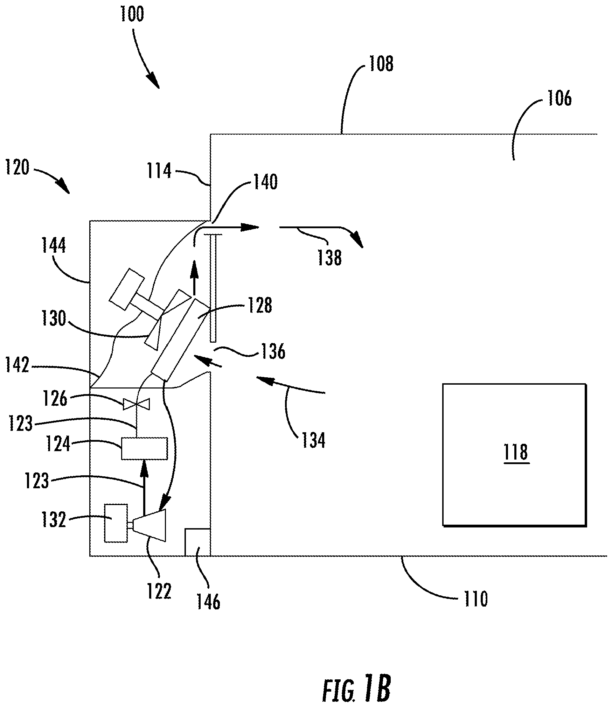

Referring now to FIG. 1B, the refrigeration unit 120 is shown in more detail. The refrigeration unit 120 includes a compressor 122, a condenser 124, an expansion valve 126, an evaporator 128, and an evaporator fan 130. The compressor 122 is operably connected to a refrigeration engine 132 which drives the compressor 122. The refrigeration engine 132 is connected to the compressor in one of several ways, such as a direct shaft drive, a belt drive, one or more clutches, and/or via an electrical generator. A refrigerant line 123 fluidly connects the components of the refrigeration unit 120.

Airflow is circulated into and through the cargo space of the container 107 by means of the refrigeration unit 120. A return airflow 134 flows into the refrigeration unit 120 from the cargo space of the container 107 through a refrigeration unit inlet 136, and across the evaporator 128 via the evaporator fan 130, thus cooling the return airflow 134 to a selected or predetermined temperature. The cooled return airflow 134, now referred to as supply airflow 138, is supplied into the cargo space of the container 107 through a refrigeration unit outlet 140, which in some embodiments is located near the top wall 108 of the container 107. The supply airflow 138 cools the cargo 118 in the cargo space of the container 107. It is to be appreciated that the refrigeration unit 120 can further be operated in reverse to warm the container 107 when, for example, the outside temperature is very low.

The refrigeration unit 120 is positioned in a frame 142 and contained in an accessible housing 144, with the frame 142 and/or the housing 144 secured to an exterior side of the front wall 114 such that the refrigeration unit 120 is positioned between the front wall 114 and the tractor 102, as shown in FIG. 1A.

The refrigeration unit 120 includes a power connector 146. Power connector 146 may be configured to receive a plug or other wired connection to supply electrical power to the refrigeration unit 120. When the container system 100 is located at a port, loaded on a ship, attached to a tractor, etc., a power supply (not shown) may be connected to the power connector 146. When the container 107 is moved from one location to another, the power connector 146 may be required to be disconnected from a power source such that the container 107 is not physically connected to or wired to a power source, enabling freedom of movement of the container 107. In some embodiments the power source include, but is not limited to, grid power, engine supplied power, auxiliary power unit power, etc.

When the power connector 146 is disconnected from a power source, the refrigeration unit 120 may not be able to be operated to continuously supply conditioned air within the cargo space of the container 107. If the power supply is absent for too long of a period, the temperature within the cargo space of the container 107 may change sufficiently to become detrimental to any cargo within the cargo space. For example, if the refrigeration unit 120 is not operated within a predetermined time period, the air temperature within the cargo space of the container 107 may rise to levels that are above desired temperatures for a specific cargo within the container 107.

It will be appreciated by those of skill in the art that the systems and configurations of FIGS. 1A and 1B are merely exemplary and provided for illustrative and descriptive purposes only. The disclosure is not limited thereby. For example, although a tractor-trailer configuration is shown, systems may be employed in other container configurations, in various truck configurations, and/or in other systems and configurations. Further, as will be appreciated by those of skill in the art, the container and cargo space may be configured as a sea container, and thus may be configured to stack with other containers and be shipped on a shipping vessel.

In any particular configuration of the trailers provided herein, proper loading of cargo within a cargo space may be important for maintaining proper cargo temperatures. That is, cargo may be loaded into a trailer or other cargo space at temperature and the cargo may need to be cooled or refrigerated, and the refrigeration unit may enable continuous temperature control of the cargo within the container. To provide cooling throughout the cargo space, airflow must be allowed to pass throughout the entire cargo space and interact with and cool the cargo.

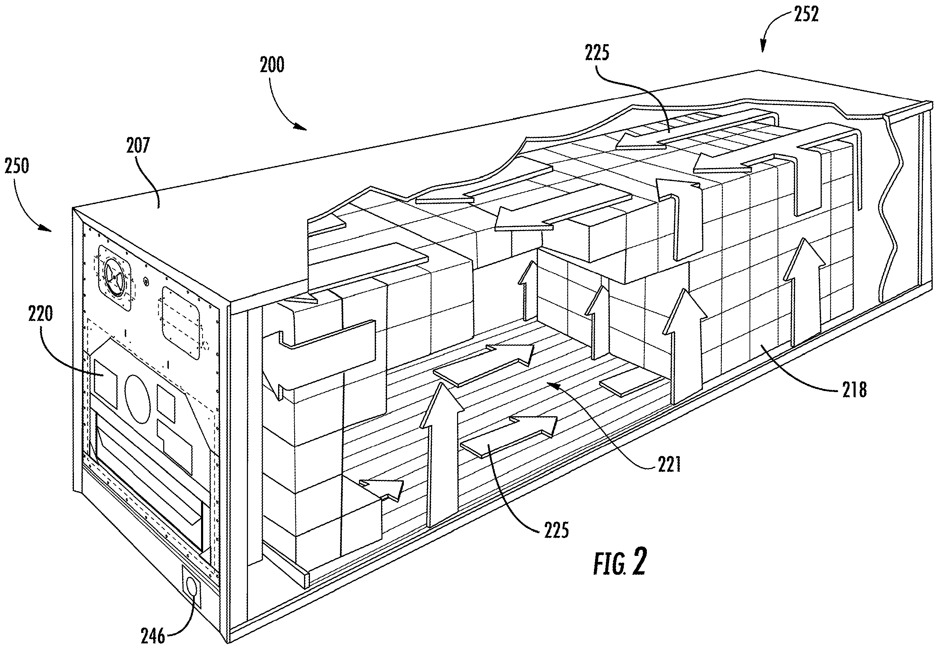

For example, referring now to FIG. 2, a container system 200 is shown. The container system 200 may include a container 207 defining a cargo space 221 and have a refrigeration unit 220. Cargo 218 may be loaded into the container 207. The cargo 218 may require cooling or refrigeration during storage and/or transport within the container 207. As shown, an airflow 225 is shown by the arrows within the cargo space 221. The airflow 225 may be generated by the refrigeration unit 220 and may be blow or conveyed throughout the cargo space 221 of the container system 200. It is noted that the refrigeration unit 220 may be located at a first end 250 of the container 207. At a second end 252 of the container 207 may be doors (not shown) that are openable such that cargo 218 may be loaded into the cargo space 221 and further may be closed to define an enclosed cargo space 221 that may be refrigerated by the refrigeration unit 220.

The refrigeration unit 220 may include a power connector 246 that may enable electrical connection between the refrigeration unit 220 and an external power unit or power source. Ensuring proper power supply may be desired to ensure that the cargo 218 is maintained within preset, known, or predetermined air quality conditions.

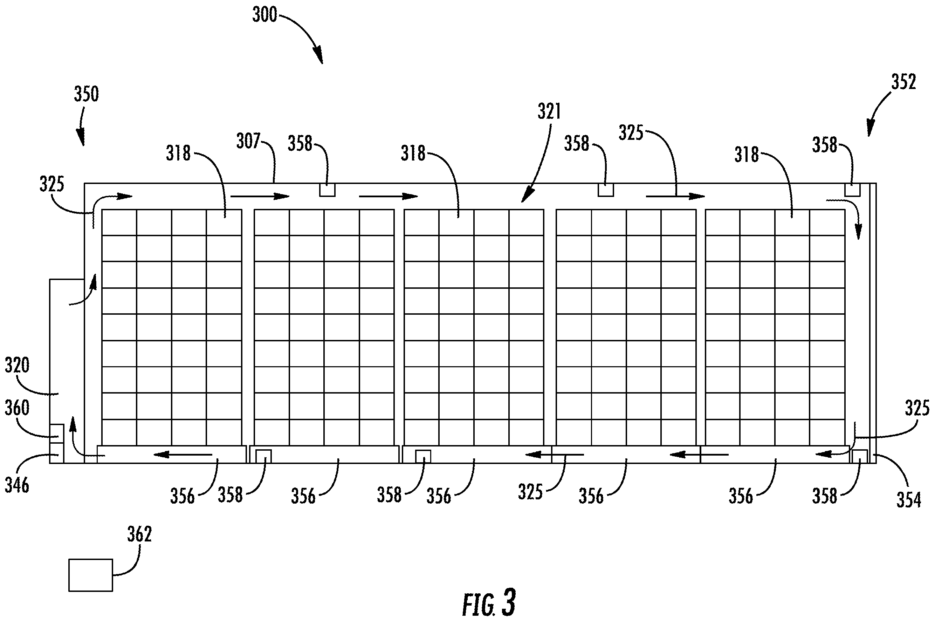

Turning now to FIG. 3, a container system 300 in accordance with a non-limiting embodiment of the present disclosure is shown. The container system 300 includes a container 307 having a refrigeration unit 320 located at a first end 350 and a door 354 located at a second end 352. The refrigeration unit 320 includes a power connector 346 configured to electrically connect to an external power source.

The container 307 defines a cargo space 321 extending from the first end 350 to the second end 352. Cargo 318 may be loaded into the cargo space 321. As shown, the cargo 318 may be stacked or located on one or more pallets. As shown, the refrigeration unit 320 may be configured to generate an airflow 325 within the cargo space 321, as indicated by the arrows in FIG. 3.

Further, as shown, the container system 300 may be configured with one or more cargo sensors 358 that may be located at one or more locations within the cargo space 321. The sensors 358 may be sensors configured to detect the physical presence of cargo 318 loaded into the cargo space 321. In one non-limiting embodiment, a single sensor may be located proximate to the doors 354. In some embodiments, the sensors 358 may be mounted to the doors 354, to the ceiling, to the floor, or even to a pallet 356 that is loaded last into the container 307. In another embodiment, for example as shown in FIG. 3, multiple cargo sensors 358 may be located throughout the cargo space 321 of the container 307. The cargo sensors 358 may be, but are not limited to, thermal sensors or cameras, wireless sensors, sensors embedded into or with cargo 318, proximity sensors, temperature sensors, or other types of sensors that may detect when a cargo 318 is located within the cargo space 321. Further, in some embodiments the detection or input of the presence of cargo 318 within the cargo space 321 may be provided by user input, such as by a keypad, controller, button, switch, etc.

A power supply sensor 360 may be operationally connected to the power connector 346. The power supply sensor 360 may be configured to monitor or determine if and when power is supplied through the power connector 346 from an external power source. For example, in one non-limiting embodiment, the power supply sensor 360 may be configured to detect a voltage or current across the power connector 346.

The cargo sensors 358 and the power supply sensor 360 may be in communication with a controller 362 that may be remote from the container 307. However, as will appreciated by those of skill in the art, the controller 362 may be configured within or on a part of the container 307, and/or may be configured as part of a controller of the refrigeration unit 320. In one non-limiting embodiment, the controller 362 is integrally connected with the power supply sensor 360. The controller 362 may be a computer or other processing device, and may contain a processor and/or memory for storing programs and/or applications. The communication between the cargo sensors 358, the power supply sensor 360, and the controller 362 may be by wired or wireless communications, including but not limited to hard wiring, Wi-Fi, Infrared, Bluetooth®, near field communication, etc. As will be appreciated by those of skill in the art, the sensors 358, 360 and the controller 362 may be powered by an auxiliary power source, such as battery power that is independent from the power supplied through the power connector 346.

The controller 362 may be configured with predetermined information regarding power supply to the refrigeration unit 320. In one example, the controller 362 may be configured with one or more predetermined data that relate to the cargo 318 loaded into the container 307 and/or data related to power supply to the refrigeration unit 320. In one non-limiting embodiment, the predetermined data may be a maximum period of time that the refrigeration unit 320 may not be connected to an external power supply. Upon loading the container 307 with cargo 318, a user may close the door 354 to seal the container 307 closed. The refrigeration unit 320 may be plugged in and activated to begin distributing air into the container 307. The power supply sensor 360 may detect the power supplied through the power connector 346. The detection of power supply may be recorded by and/or input into the controller 362. Further, when cargo 318 is loaded into the cargo space 321, the cargo sensors 358 may detect the cargo 318 and the detection may be recorded by and/or input into the controller 362. Thus the controller 362 may include information regarding a current state of power supply and a current state of loading of the container 307.

The controller 362 may be configured to monitor for various conditions. For example, the controller 362 may be configured to monitor the power supply supplied through the power connector 346 when it is determined there is cargo 318 loaded into the cargo space 321. If it is determined that the power supply is not present, i.e., no power is provided to the refrigeration unit 320, after a predetermined time period , the controller 362 may be configured to provide an indicator, such as an alarm, message, or other notification, that the refrigeration unit 320 doesn't have power and is not operating. The indicator may be used to indicate that a power cord, plug, or wire is not plugged into the power connector 346 and power should be provided to maintain the cargo space 321 at an appropriate or desired temperature.

In some embodiments, the indicator may be a light or speaker that is attached to and/or in proximity with the container such that a person that loaded the container may be notified that power is not being properly supplied to the refrigeration unit. For example, a flashing light and/or an announcement may be provided at the container itself. In some embodiments, the notification may be an email, text message, or other notification sent from the controller to a user of the system, such as a person in charge of a cargo area at a seaport. Accordingly, personnel loading, storing, or moving containers may be notified that the power to a specific container may be lost and the refrigeration unit of the container should be powered, e.g., a power source should be plugged into a power connector of the container.

In some embodiments, the controller 362 may be in communication with a number of containers 307 each configured with cargo sensors 358 and power supply sensors 360. The controller 362 may be configured to determine if one or more of the containers 307 has a loss of power or failure of the refrigeration unit 320 to start, and further the controller 362 may be configured to identify which of a plurality of containers 307 does not have power. This may be beneficial for when a container 307 is moved and the cargo 318 within the container 307 may shift and block a necessary airflow within the container.

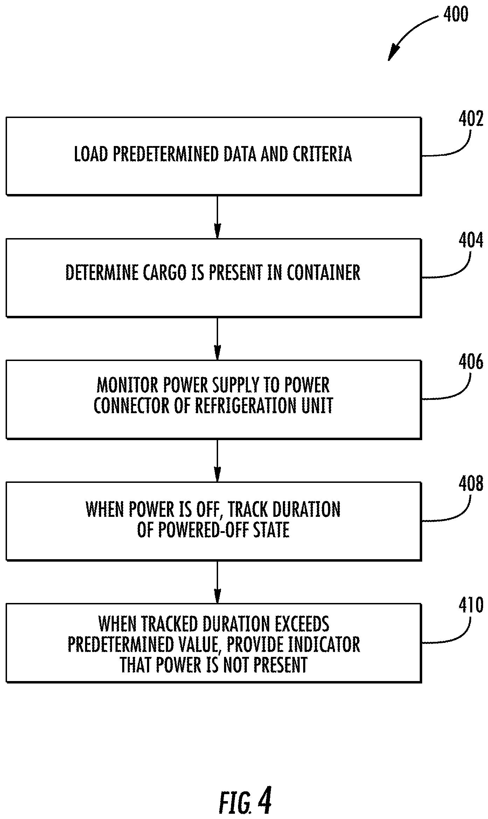

Turning now to FIG. 4, a flow process in accordance with a non-limiting embodiment of the present disclosure is shown. The flow process 400 shown in FIG. 4 may be performed by a controller or other device that is in communication with one or more sensors that are located within a container, including at least one cargo sensor and at least one power supply sensor. For example, in one non-limiting embodiment, the flow process 400 may be performed by the controller 362 shown in FIG. 3.

The controller may load predetermined data and/or criteria, as shown at block 402. The predetermined data and criteria may be information related to power requirements, refrigeration requirements, and/or cargo information. For example, the predetermined data may represent at least a predetermined time that represents a maximum duration that a refrigeration unit on a container is not powered on. In some embodiments, the predetermined data and criteria may be based on a specific cargo or type of cargo that will be loaded into a container for storage and/or transportation. For example, certain cargo or types of cargo may be able to have a powered-off state exist for longer than other cargo or types of cargo. The powered-off state, as used herein, represents a state wherein the cargo container is loaded with cargo and the refrigeration unit is not receiving power as detected by a power supply sensor.

In some embodiments, the predetermined data may be a generic set of data for any cargo loading configuration, i.e., a predetermined maximum duration of a refrigeration unit being powered-off with a container in a loaded state. That is, in some embodiments, the predetermined data may be the same for any cargo. As noted, in other embodiments, the predetermined information may be dependent upon a particular cargo or cargo type.

The predetermined data may be loaded prior to, during, or after a container is loaded with cargo. If a particular cargo or cargo type is to be loaded into a container, predetermined data associated with that particular cargo or cargo type may be loaded onto and stored in a memory of the controller.

At block 404, the controller may determine that cargo is present within the container. For example, one or more cargo sensors may be used to detect the presence of cargo in a cargo space of a container. The sensors may be any type of sensor or detector used to detect the presence of cargo in a container, as discussed above. Alternatively, or in combination therewith, the determination may be based on user input, such as a user input into the controller directly (electronically or otherwise).

At block 406, when it is determined that cargo is present in the container, the controller is configured to monitor a power supply to a refrigeration unit of the container. The controller is programed or configured to detect when the power is disconnected or is stopped being supplied to the refrigeration unit. For example, the controller may be configured to detect when a plug or other device is unplugged or separated from a power connector and/or may be able to detect if a fault occurs in or damage occurs to a power supply line such that power is no longer supplied to the refrigeration unit.

When the controller detects a powered-off state of the refrigeration unit, by detecting that power is no longer supplied into or through a power connector, the controller may track or monitor the duration or time that the power is absent or lost, as shown at block 408. The tracking and monitoring may be performed by the controller or other computer processor that includes a processing unit and/or memory for processing data obtained from a power supply sensor. During this process, the controller may track a total time that the refrigeration unit is without power, as provided through a power connector and detected by a power supply sensor.

Tracking may include live monitoring, including a clock or timer that starts counting when power is no longer detected by the power supply sensor. Further, the tracked time may be logged or recorded and stored for later retrieval and/or review. As such, a record of the duration of a refrigeration unit not being active or without power may be provided.

When it is determined that the measured time of powered-off state exceeds the predetermined time period, the controller may be configured to provide an indicator that the refrigeration unit is without power, as shown at block 410. For example, the controller may receive data from the power supply sensor or may detect a lack of information/data from the power supply sensor, depending on the configuration, indicating a time of power-off status. The controller may determine that the power-off status exists for a period or duration of time that exceeds a predetermined value and indicate that such time has been exceeded.

The indicator provided by the controller at block 410 may be a flashing light or sound generated by a speaker on the container to indicate to a person in proximity to the container to be notified of the lack of power provided to the refrigeration unit. In some embodiments, the indicator may be a notification or alert in a computer program that may be used by a user. Further, in some embodiments, the indicator may be a message (e.g., text or email) that is sent to a user of the system.

As will be appreciated by those of skill in the art, the flow process 400 may be performed as a monitoring process for a loaded container, i.e., a container having cargo loaded therein. The flow process 400 may be prompted by the locking or closing of the exterior doors of the container, and block 406 may be continuous performed until a powered-off state is detected. In another configuration, the loss of power detected at the power connector may prompt the controller to monitor. That is, in some embodiments, the controller may not continuously monitor the power supply sensor, but rather the tracking of the duration of time without power (e.g., block 408) may be prompted by the loss of power through or at the power supply sensor.

Advantageously, embodiments described herein provide a system for monitoring a power supply to a refrigeration unit of a container, trailer, reefer, etc. Advantageously, in accordance with various embodiments, proper cooling of cargo may be ensured and maintained with systems and processes described herein. Moreover, advantageously, improper or wrong power connections to a refrigeration unit may be detected and corrected, thus reducing cargo claims and/or damage to cargo due to improper cooling conditions, e.g., periods of time that exceed recommended durations for cargo. Further, advantageously, as provided herein, a user may be notified of loss of power to a refrigeration unit. Additionally, advantageously, in accordance with some embodiments, remote notification and monitoring of multiple containers may be enabled such that embodiments provided herein may be used in cargo yards and/or shipping yards where many containers may be collected and/or stored with cargo contained within the containers.

While the present disclosure has been described in detail in connection with only a limited number of embodiments, it should be readily understood that the present disclosure is not limited to such disclosed embodiments. Rather, the present disclosure can be modified to incorporate any number of variations, alterations, substitutions, combinations, sub-combinations, or equivalent arrangements not heretofore described, but which are commensurate with the scope of the present disclosure. Additionally, while various embodiments of the present disclosure have been described, it is to be understood that aspects of the present disclosure may include only some of the described embodiments.

For example, although a container having a refrigeration unit is shown and described, those of skill in the art will appreciate that the systems and processes may be used and employed with other storage mechanisms, such as storage rooms, coolers, chillers, etc., particularly spaces that may be used to house cargo or other items that are to be refrigerated and/or maintained as specific air quality levels.

Further, embodiments described herein may be used for containers that are pulled by tractors and the power is supplied by the tractor or other engine or power supply. In such embodiments, the indicator may be configured to work with a mobile container, e.g., a text notification, a flashing light, etc.

Accordingly, the present disclosure is not to be seen as limited by the foregoing description, but is only limited by the scope of the appended claims.

## Claims

1. A system for monitoring power supply to a refrigeration unit (120) of a container (107), the system comprising:
one or more cargo sensors (358) located within the container (107) configured to detect a cargo within the container (107);
a power connector (346) configured to receive power from a power supply, the power connector (346) operably connected to the refrigeration unit (120) to supply power thereto;
a power supply sensor (360) operably connected to the power connector (346), the power supply sensor (360) configured to detect a lack of power supplied through the power connector (346); and
a controller (362) in communication with the one or more cargo sensors (358) and the power supply sensor (360), the controller (362) configured to:
store predetermined information related to power requirements of the refrigeration unit (12), wherein the predetermined information includes a maximum time period of a powered-off state;
receive data from the one or more cargo sensors (358);
receive data from the power supply sensor (360); and
when the data from the one or more cargo sensors (358) indicates the presence of cargo within the container (107) and the data from the power supply sensor (360) indicates a lack of power for a duration that exceeds the maximum time period, the controller (362) is configured to provide an indicator that the refrigeration unit (120) does not have power;
wherein the power supply sensor (360) is configured to detect a voltage or current across the power connector (346); and
wherein the power supply sensor (360) and the controller (362) are powered by an auxiliary power source.

2. The system of claim 1, wherein at least one sensor of the one or more cargo sensors (358) is a proximity sensor.

3. The system of any of the preceding claims, wherein the power supply sensor (360) is configured to detect a voltage received from a power supply at the power connector (346).

4. The system of any of the preceding claims, wherein the indicator is one of a light, a noise provided at the container, or
a message transmitted to a user.

5. The system of any of the preceding claims, further comprising a plurality of containers (107), each container (107) having one or more cargo sensors (358) and each container (107) having a power supply sensor (360), the system further comprising the controller (362) in communication with each of the plurality of containers (107).

6. The system of claim 5, wherein, when one container (107) of the plurality of containers (107) has a lack of power for a duration that exceeds a maximum time period of the respective container (107), the indicator is configured to identify which of the plurality of containers (107) has a lack of power for a duration that exceeds the maximum time period.

7. The system of any of the preceding claims, wherein the predetermined information is based on a cargo type loaded into the container (107).

8. The system of any of the preceding claims, wherein the controller (362) is further configured to log a duration of time that exceeds the maximum time period.

9. A method for monitoring power supply to a refrigeration unit (120) of a container (107), the method comprising:
loading, at a controller (362), predetermined information related to related to power requirements of the refrigeration unit (120), wherein the predetermined information includes a maximum time period of a powered-off state;
detecting, with one or more cargo sensors (358), the presence of cargo within the container (107);
monitoring, with a power supply sensor (360), a power supplied to the refrigeration unit (120) through a power connector (346); and
providing an indicator when it is determined that the refrigeration unit (120) is without power for a duration that exceeds the maximum time period;
wherein the power supply sensor (360) is configured to detect a voltage or current across the power connector (346); and
wherein the power supply sensor (360) and the controller (362) are powered by an auxiliary power source.

10. The method of claim 9, wherein at least one sensor of the one or more cargo sensors (358) is a proximity sensor.

11. The method of any of claims 9-10, wherein the power supply sensor (360) is configured to detect a voltage received from a power supply at the power connector (346).

12. The method of any of claims 9-11, wherein the indicator is one of a light or a noise provided at the container (107), the method further comprising activating said light or noise; and/or
wherein the indicator is a message transmitted to a user, the method further comprising transmitting said message.

13. The method of any of claims 9-12, further comprising a plurality of containers (107), each container (107) having one or more cargo sensors (358) and each container (107) having a power supply sensor (360), the method further comprising monitoring each of the plurality of containers (107) with the controller (362).

14. The method of claim 13, wherein, when one container (107) of the plurality of containers (107) has a lack of power for a duration that exceeds a maximum time period of the respective container (107), the method further comprises identify which of the plurality of containers (107) has a lack of power exceeding the maximum time period.

15. The method of any of claims 9-14, wherein the predetermined information is based on a cargo type loaded into the container (107); and/or
wherein the method
further comprises logging a duration of time that exceeds the maximum time period.

## Patentansprüche

1. System zur Überwachung der Stromversorgung zu einer Kühleinheit (120) eines Behälters (107), wobei das System Folgendes umfasst:
einen oder mehrere Frachtsensoren (358), die sich innerhalb des Behälters (107) befinden und dazu konfiguriert sind, eine Fracht innerhalb des Behälters (107) zu erfassen;
einen Stromanschluss (346), der dazu konfiguriert ist, Strom von einer Stromversorgung zu empfangen, wobei der Stromanschluss (346) mit der Kühleinheit (120) wirkverbunden ist, um diese mit Strom zu versorgen;
einen Stromversorgungssensor (360), der mit dem Stromanschluss (346) wirkverbunden ist, wobei der Stromversorgungssensor (360) dazu konfiguriert ist, einen Mangel an Strom zu erfassen, der durch den Stromanschluss (346) zugeführt wird; und
eine Steuerung (362) in Kommunikation mit dem einen oder den mehreren Frachtsensoren (358) und dem Stromversorgungssensor (360), wobei die Steuerung (362) zu Folgendem konfiguriert ist:
Speichern vorbestimmter Information in Bezug auf Stromanforderungen der Kühleinheit (12), wobei die vorbestimmte Information eine maximale Zeitdauer eines ausgeschalteten Zustands beinhaltet;
Empfangen von Daten von dem einen oder den mehreren Frachtsensoren (358);
Empfangen von Daten von dem Stromversorgungssensor (360); und
wenn die Daten von dem einen oder den mehreren Frachtsensoren (358) das Vorhandensein von Fracht innerhalb des Behälters (107) anzeigen und die Daten von dem Stromversorgungssensor (360) einen Mangel an Strom für eine Dauer, die den maximalen Zeitraum überschreitet, anzeigen, die Steuerung (362) dazu konfiguriert ist, einen Indikator bereitzustellen, dass die Kühleinheit (120) keinen Strom hat;
wobei der Stromversorgungssensor (360) dazu konfiguriert ist, eine Spannung oder einen Strom über den Stromanschluss (346) zu erfassen; und
wobei der Stromversorgungssensor (360) und die Steuerung (362) von einer Hilfsstromquelle mit Strom versorgt werden.

2. System nach Anspruch 1, wobei mindestens ein Sensor des einen oder der mehreren Frachtsensoren (358) ein Näherungssensor ist.

3. System nach einem der vorhergehenden Ansprüche, wobei der Stromversorgungssensor (360) dazu konfiguriert ist, eine Spannung zu erfassen, die von einer Stromversorgung an dem Stromanschluss (346) empfangen wird.

4. System nach einem der vorhergehenden Ansprüche, wobei der Indikator eines von einem Licht, einem Geräusch, das an dem Behälter bereitgestellt wird, oder einer an einen Benutzer übertragenen Nachricht ist.

5. System nach einem der vorhergehenden Ansprüche, ferner umfassend eine Vielzahl von Behältern (107), wobei jeder Behälter (107) einen oder mehrere Frachtsensoren (358) aufweist und jeder Behälter (107) einen Stromversorgungssensor (360) aufweist, wobei das System ferner die Steuerung (362) in Kommunikation mit jedem der Vielzahl von Behältern (107) umfasst.

6. System nach Anspruch 5, wobei, wenn ein Behälter (107) der Vielzahl von Behältern (107) einen Mangel an Strom für eine Dauer, die eine maximale Zeitdauer des jeweiligen Behälters (107) überschreitet, aufweist, der Indikator dazu konfiguriert ist, zu identifizieren, welcher der Vielzahl von Behältern (107) einen Mangel an Strom für eine Dauer, die den maximalen Zeitraum überschreitet, aufweist.

7. System nach einem der vorhergehenden Ansprüche, wobei die vorbestimmte Information auf einer in dem Behälter (107) geladenen Frachtart basiert.

8. System nach einem der vorhergehenden Ansprüche, wobei die Steuerung (362) ferner dazu konfiguriert ist, eine Zeitdauer zu protokollieren, die den maximalen Zeitraum überschreitet.

9. Verfahren zur Überwachung der Stromversorgung zu einer Kühleinheit (120) eines Behälters (107), wobei das Verfahren Folgendes umfasst:
Laden von vorbestimmter Information in Bezug auf Stromanforderungen der Kühleinheit (120) an einer Steuerung (362), wobei die vorbestimmte Information einen maximalen Zeitraum eines ausgeschalteten Zustands beinhaltet;
Erfassen des Vorhandenseins von Fracht innerhalb des Behälters (107) mit einem oder mehreren Frachtsensoren (358);
Überwachen eines Stroms, der der Kühleinheit (120) durch einen Stromanschluss (346) zugeführt wird, mit einem Stromversorgungssensor (360); und
Bereitstellen eines Indikators, wenn festgestellt wird, dass die Kühleinheit (120) für eine Dauer, die den maximalen Zeitraum überschreitet, ohne Strom ist;
wobei der Stromversorgungssensor (360) dazu konfiguriert ist, eine Spannung oder einen Strom über den Stromanschluss (346) zu erfassen; und
wobei der Stromversorgungssensor (360) und die Steuerung (362) von einer Hilfsstromquelle mit Strom versorgt werden.

10. Verfahren nach Anspruch 9, wobei mindestens ein Sensor des einen oder der mehreren Frachtsensoren (358) ein Näherungssensor ist.

11. Verfahren nach einem der Ansprüche 9-10, wobei der Stromversorgungssensor (360) dazu konfiguriert ist, eine Spannung zu erfassen, die von einer Stromversorgung an dem Stromanschluss (346) empfangen wird.

12. Verfahren nach einem der Ansprüche 9-11, wobei der Indikator eines von einem Licht oder einem Geräusch, das an dem Behälter (107) bereitgestellt wird, ist, wobei das Verfahren ferner das Aktivieren des Lichts oder des Geräusches umfasst; und/oder
wobei der Indikator eine an einen Benutzer übertragene Nachricht ist, wobei das Verfahren ferner das Übertragen der Nachricht umfasst.

13. System nach einem der Ansprüche 9-12, ferner umfassend eine Vielzahl von Behältern (107), wobei jeder Behälter (107) einen oder mehrere Frachtsensoren (358) aufweist und jeder Behälter (107) einen Stromversorgungssensor (360) aufweist, wobei das Verfahren ferner das Überwachen jedes der Vielzahl von Behältern (107) mit der Steuerung (362) umfasst.

14. Verfahren nach Anspruch 13, wobei, wenn ein Behälter (107) der Vielzahl von Behältern (107) einen Mangel an Strom für eine Dauer, die einen maximalen Zeitraum des jeweiligen Behälters (107) überschreitet, aufweist, das Verfahren ferner umfasst, zu identifizieren, welche der Vielzahl von Behältern (107) einen Mangel an Strom aufweist, der den maximalen Zeitraum überschreitet.

15. Verfahren nach einem der Ansprüche 9-14, wobei die vorbestimmte Information auf einer in dem Behälter (107) geladenen Frachtart basieren; und/oder
wobei das Verfahren
ferner das Protokollieren einer Zeit, die den maximalen Zeitraum überschreitet, umfasst.

## Revendications

1. Système de surveillance de l'alimentation électrique d'une unité de réfrigération (120) d'un conteneur (107), le système comprenant :
un ou plusieurs capteurs de cargaison (358) situés à l'intérieur du conteneur (107) conçus pour détecter une cargaison à l'intérieur du conteneur (107) ;
un connecteur d'alimentation (346) conçu pour recevoir une puissance provenant d'une alimentation électrique, le connecteur d'alimentation (346) étant relié de manière fonctionnelle à l'unité de réfrigération (120) pour fournir une puissance à celle-ci ;
un capteur d'alimentation électrique (360) relié de manière fonctionnelle au connecteur d'alimentation (346), le capteur d'alimentation électrique (360) étant conçu pour détecter un manque de puissance fournie à travers le connecteur d'alimentation (346) ; et
un dispositif de commande (362) en communication avec les un ou plusieurs capteurs de cargaison (358) et le capteur d'alimentation électrique (360), le dispositif de commande (362) étant conçu pour :
stocker des informations prédéterminées liées à la puissance nécessaire à l'unité de réfrigération (12), dans lequel les informations prédéterminées comportent une période de temps maximale d'un état inactif ;
recevoir des données provenant des un ou plusieurs capteurs de cargaison (358) ;
recevoir des données provenant du capteur d'alimentation électrique (360) ; et
lorsque les données provenant des un ou plusieurs capteurs de cargaison (358) indiquent la présence d'une cargaison à l'intérieur du conteneur (107) et les données provenant du capteur d'alimentation électrique (360) indiquent un manque de puissance pendant une durée qui dépasse la période de temps maximale, le dispositif de commande (362) étant conçu pour fournir un indicateur selon lequel l'unité de réfrigération (120) n'est pas alimentée ;
dans lequel le capteur d'alimentation électrique (360) est conçu pour détecter une tension ou un courant à travers le connecteur d'alimentation (346) ; et
dans lequel le capteur d'alimentation électrique (360) et le dispositif de commande (362) sont alimentés par une source d'alimentation auxiliaire.

2. Système selon la revendication 1, dans lequel au moins un capteur des un ou plusieurs capteurs de cargaison (358) est un capteur de proximité.

3. Système selon l'une quelconque des revendications précédentes, dans lequel le capteur d'alimentation électrique (360) est conçu pour détecter une tension reçue d'une alimentation électrique au niveau du connecteur d'alimentation (346) .

4. Système selon l'une quelconque des revendications précédentes, dans lequel l'indicateur est un parmi une lumière, un bruit prévu au niveau du conteneur, ou un message transmis à un utilisateur.

5. Système selon l'une quelconque des revendications précédentes, comprenant en outre une pluralité de conteneurs (107), chaque conteneur (107) ayant un ou plusieurs capteurs de cargaison (358) et chaque conteneur (107) ayant un capteur d'alimentation électrique (360), le système comprenant en outre le dispositif de commande (362) en communication avec chacun de la pluralité de conteneurs (107).

6. Système selon la revendication 5, dans lequel, lorsqu'un conteneur (107) de la pluralité de conteneurs (107) a un manque de puissance pendant une durée qui dépasse une période de temps maximale du conteneur respectif (107), l'indicateur est conçu pour identifier lequel parmi la pluralité de conteneurs (107) a un manque de puissance pendant une durée qui dépasse la période de temps maximale.

7. Système selon l'une quelconque des revendications précédentes, dans lequel les informations prédéterminées sont basées sur un type de cargaison chargé dans le conteneur (107).

8. Système selon l'une quelconque des revendications précédentes, dans lequel le dispositif de commande (362) est en outre conçu pour enregistrer une durée qui dépasse la période de temps maximale.

9. Procédé de surveillance de l'alimentation électrique d'une unité de réfrigération (120) d'un conteneur (107), le procédé comprenant :
le chargement, au niveau d'un dispositif de commande (362), d'informations prédéterminées liées à la puissance nécessaire à l'unité de réfrigération (120), dans lequel les informations prédéterminées comportent une période de temps maximale d'un état inactif ;
la détection, avec un ou plusieurs capteurs de cargaison (358), de la présence d'une cargaison à l'intérieur du conteneur (107) ;
la surveillance, au moyen d'un capteur d'alimentation électrique (360), d'une puissance fournie à l'unité de réfrigération (120) à travers un connecteur d'alimentation (346) ; et
la fourniture d'un indicateur lorsqu'il est déterminé que l'unité de réfrigération (120) est non alimentée pendant une durée qui dépasse la période de temps maximale ;
dans lequel le capteur d'alimentation électrique (360) est conçu pour détecter une tension ou un courant à travers le connecteur d'alimentation (346) ; et
dans lequel le capteur d'alimentation électrique (360) et le dispositif de commande (362) sont alimentés par une source d'alimentation auxiliaire.

10. Procédé selon la revendication 9, dans lequel au moins un capteur des un ou plusieurs capteurs de cargaison (358) est un capteur de proximité.

11. Procédé selon l'une quelconque des revendications 9 à 10, dans lequel le capteur d'alimentation électrique (360) est conçu pour détecter une tension reçue d'une alimentation électrique au niveau du connecteur d'alimentation (346).

12. Procédé selon l'une quelconque des revendications 9 à 11, dans lequel l'indicateur est un parmi une lumière ou un bruit prévu au niveau du conteneur (107), le procédé comprenant en outre l'activation de ladite lumière ou dudit bruit ; et/ou dans lequel l'indicateur est un message transmis à un utilisateur, le procédé comprenant en outre la transmission dudit message.

13. Procédé selon l'une quelconque des revendications 9 à 12, comprenant en outre une pluralité de conteneurs (107), chaque conteneur (107) ayant un ou plusieurs capteurs de cargaison (358) et chaque conteneur (107) ayant un capteur d'alimentation électrique (360), le procédé comprenant en outre la surveillance de chacun de la pluralité de conteneurs (107) avec le dispositif de commande (362).

14. Procédé selon la revendication 13, dans lequel, lorsqu'un conteneur (107) de la pluralité de conteneurs (107) a un manque de puissance pendant une durée qui dépasse une période de temps maximale du conteneur respectif (107), le procédé comprend en outre l'identification duquel parmi la pluralité de conteneurs (107) a un manque de puissance dépassant la période de temps maximale.

15. Procédé selon l'une quelconque des revendications 9 à 14, dans lequel les informations prédéterminées sont basées sur un type de cargaison chargé dans le conteneur (107) ; et/ou
dans lequel le procédé
comprend en outre l'enregistrement d'une durée qui dépasse la période de temps maximale.
